# EUROPEAN PATENT APPLICATION

(11) **EP 1 804 196 A1**
(43) Date of publication of application: **04.07.2007**
(21) Application number: 05301120.1
(22) Date of filing: 29.12.2005
(51) Int. Cl.: G06K 19/07

(54) **Method and devices for data access in combined SIM and mass storage cards**

(71) Applicant: MOTOROLA, INC., Schaumburg, IL 60196 (US)
(72) Inventor: Gasparini, Stéphane, 31170, TOURNEFEUILLE (FR); Machado, Georgina C., 60046, LAKE VILLA (US)
(74) Representative: Joly, Jean-Jacques

(57) **Abstract**

Disclosed is a memory card (203), a device and methods for maintaining and utilizing a bridge data bus (224) between the two interfaces (220, 222) of a combo-SIM or equivalent chip card (203). The memory card (203) includes first (216) and second data buses (218) operatively coupled to the external interface (212), the second data bus (218) having faster data transfer capability than the first data bus (216). The memory card (203) includes a subscriber identity block (209) and a mass storage block (215). The subscriber identity block (209) is coupled to the external interface (212) via the first data bus (216), and is effective to store subscriber identity information. The mass storage block (215) is coupled to the external interface (212) via the second data bus (218). The memory card (203) includes a third data bus (224) coupled between the subscriber identity block (209) and the mass storage block (215), the third data (224) bus having faster data transfer capability than the first data bus (216).

## Description

### FIELD

The present disclosure relates to memory cards for mobile communication devices, and more particularly to subscriber identity block access in a memory card through a mass storage block.

### BACKGROUND

A mobile communication device such as a cellular telephone can incorporate a Subscriber Identity Module (SIM) or other identification chip for maintaining and collecting user subscription information. The SIM card can identify the user to a network, assuring the authentication during access into the network. With its functionality and capability to support further sophisticated identification services such as storage of digital signatures and other network access codes, the SIM card is the key security token for any Global System for Mobile Communication (GSM) telephone.

A SIM is a smart chip card, having an approximate size of a postage stamp. A SIM card typically contains a microprocessor and memory that can be an EEPROM, or in the newest configurations, a NAND (not AND) Flash memory, which provides ample memory space for storing more than user identification such as a user's phonebook containing hundreds of personal phone numbers, text messages and other value-added services.

A combo-SIM is a device that presents two separate interfaces with the host device. One interface supports a transfer protocol, International Standards Organization (ISO) of a typical SIM card, transferring data at rather slow rates, such as 140Kbits/second. As a result, the user interface can be very slow. A solution to the slow ISO protocol transfer is to cache the SIM data within the phone memory, a redundant use of storage which is not an ideal use of memory.

Another interface of the combo-SIM supports high speed transfer rates of Random Access Memory (RAM) up to 100Mbit/second. In this way the memory capacity of the mobile communication device can be increased. While there may be one processor that manages both functions of the combo-SIM, the functions are independent from one another and there is no link between them. It would be beneficial were the SIM data to be accessed as quickly as that of the RAM data.

### BRIEF DESCRIPTION OF THE DRAWINGS

FIG. 1 depicts a mobile communication device such as a cellular telephone, including certain component parts and certain modules;

FIG. 2 depicts certain components of a combo-SIM card;

FIG. 3 is a flow chart showing the initialization process that the described combo-SIM card may follow;

FIG. 4 is a flow chart of an encapsulation process of the described combo-SIM card;

FIG. 5 is a flow chart of mass storage software determining whether the command is encapsulated for accessing the SIM data; and

FIG. 6 is a flow chart of the SIM software accessing the SIM data via the third bus or accessing RAM data.

### DETAILED DESCRIPTION

Disclosed is a memory card, a device and methods for maintaining and utilizing a bridge data bus between the two interfaces of a combo-SIM or equivalent chip card. Where the two interfaces otherwise operate independently, as disclosed herein, the mass storage software interface may have access to the SIM data, and thus may transfer the SIM data according to a fast protocol rather than the slow ISO protocol. Accordingly, the SIM data may be transferred at a speed substantially matching that of a transfer of mass storage data, for example, that of a USB protocol.

Generally, a combo-SIM memory card or similar identification card for an electronic device may include first and second data buses operatively coupled to the external interface. That is, the first data bus may be coupled between the subscriber identity block (that may be SIM NAND Flash memory) and an interface. The subscriber identity block coupled to the first data bus may be effective to store subscriber identity information and other information. The subscriber identity block may include both the SIM software and the SIM memory, and is also referred to as the SIM software as it is below with reference to the drawings. The second data bus may be coupled between a mass storage block (RAM) and the host device interface. The mass storage block may be coupled to the second data bus and may be effective to store non-subscriber identity information. The mass storage block may include both the mass storage software and RAM and may also be referred to as the mass storage software as it is below with reference to the drawings. As discussed above, the second data bus may have faster data transfer capability than the first data bus. A data bus may also be referred to herein as a bus.

As disclosed herein, a third data bus may be operatively coupled between the subscriber identity block and the mass storage block. Accordingly, the mass storage block may transfer SIM data via the third bus and the second bus to the device interface. The third data bus, like the second data bus may have a high speed data transfer capability than the first data bus. Accordingly, subscriber identity block data may be transferred at the faster rate of the second data bus than were it transferred according to the ISO protocol of the SIM.

The instant disclosure is provided to further explain in an enabling fashion the best modes of making and using various embodiments in accordance with the present invention. The disclosure is further offered to enhance an understanding and appreciation for the invention principles and advantages thereof, rather than to limit in any manner the invention. The invention is defined solely by the appended claims including any amendments of this application and all equivalents of those claims as issued.

It is further understood that the use of relational terms, if any, such as first and second, top and bottom, and the like are used solely to distinguish one from another entity or action without necessarily requiring or implying any actual such relationship or order between such entities or actions. Much of the inventive functionality and many of the inventive principles are best implemented with or in software programs or instructions and integrated circuits (ICs) such as application specific ICs. It is expected that one of ordinary skill, notwithstanding possibly significant effort and many design choices motivated by, for example, available time, current technology, and economic considerations, when guided by the concepts and principles disclosed herein will be readily capable of generating such software instructions and programs and ICs with minimal experimentation. Therefore, in the interest of brevity and minimization of any risk of obscuring the principles and concepts according to the present invention, further discussion of such software and ICs, if any, will be limited to the essentials with respect to the principles and concepts within the preferred embodiments.

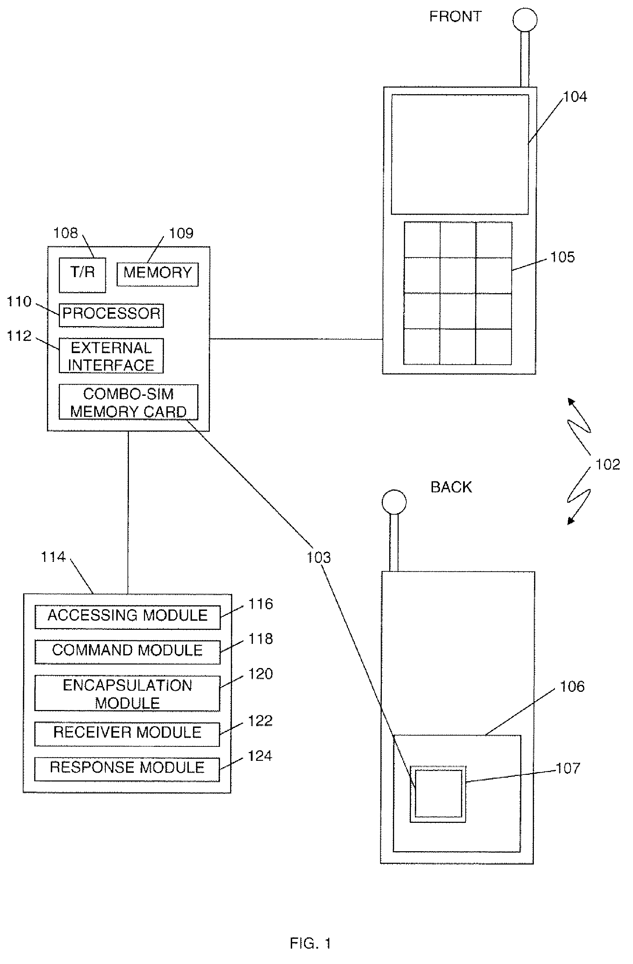

FIG. 1 depicts a mobile communication device such as a cellular telephone, including certain component parts and certain modules. The device 102 may be a mobile communication device, and in particular, a cellular telephone. It is understood that any device that may utilize a SIM card 103 is within the scope of this discussion. For example, devices that utilize SIM cards include cellular telephones, messaging devices, mobile telephones, personal digital assistants (PDAs), notebook or laptop computers incorporating communication modems, mobile data terminals, application specific gaming devices, video gaming devices incorporating wireless modems, and the like. As previously mentioned, there are cards equivalent to the SIM. For example, a User Identity Module (UIM) also known as a Removable User Identity Module (R-UIM) is an identity module for standards other than GSM (notably Code Division Multiple Access (CDMA)). It is understood that any type subscriber identity card is within the scope of this discussion.

The device 102 is shown having a front side and a back side. The front side may include, for example a display 104 and keypad 105. The backside of the device 102 may include a battery housing or holder 106. Oftentimes a SIM card 103 may be accessed within the device by a user by removing a door 107 within the battery housing or by other manners. The SIM card 103 may be accessible since it may contain identity information that a user may wish to transfer to a different device. Accordingly, the SIM card 103 may be a removable memory card and one card may be used by any number of devices.

The device 102 may further include one or more transceivers (transmitter/receiver) 108 for communication with one or more networks with which subscriber identity information may be exchanged. The combo-SIM card discussed below may of course include more than subscriber identity block information for communication with a plurality of networks. The device may further include a memory 109 and a processor 110 that may interact with SIM card 103 via interface 112.

Also shown in FIG. 1 are certain modules that may carry out certain processes of the methods as described herein. They include an accessing module 116, a command module 118, an encapsulation module 120, a receiver module 122 and a response module 124. The modules 114 that may be implemented in software, such as in the form of one or more sets of prestored instructions, and/or hardware, which facilitate the operation of the device as discussed below. The functions of these modules and other functions will be discussed in more detail below.

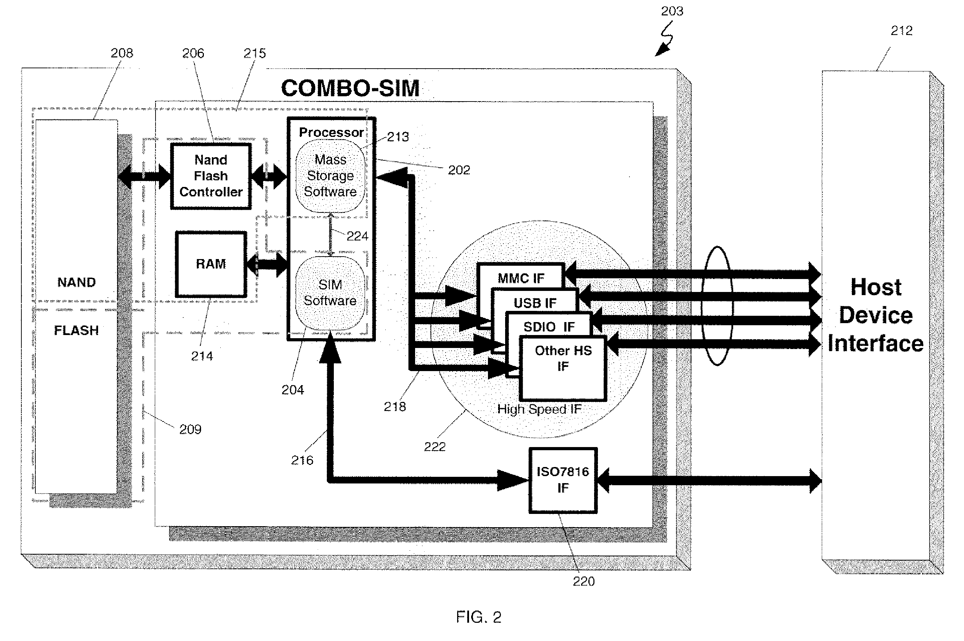

FIG. 2 depicts certain components of a combo-SIM card. As previously discussed, the combo-SIM card 203 contains a microprocessor chip 202 for running at least one SIM software application 204 that collects and stores unique subscription information about a user's account, including the user's phone number and other non-identity related information. The SIM software application may be in communication with a NAND Flash controller 206 and therefore the NAND Flash memory 208 and therefore taken together are the subscriber identity block 209. Other elements of the combo-SIM card may be included in the subscriber identity block 209. The microprocessor chip 202 may also process mass storage software 213 to access RAM 214 that may contain information of a different type or the same type as that of the NAND Flash memory and therefore take together are the mass storage block 215. Other elements of the combo-SIM card may be included in the mass storage block 215.

The first bus 216 may couple the external interface 212 of the host device (see 102 of FIG. 1) with the SIM software. The second bus 218 may couple the interface 212 of the host device with the mass storage software 213. As indicated in the drawing, the first bus 216 communicates via an ISO interface 220. As mentioned above, the speed of a SIM transfer from the NAND Flash memory 208 is 140 Kbps which is slow due to the ISO protocol. Also indicated in the drawing is that the second bus may communicate with the host device interface via a high speed protocol interface 222 that may include, for example, a MMC, USB, SDIO or other high speed protocol with a data transfer rate that may be as high as 2.5Mbytes/s. Of course, as advancements are made, these numbers may improve.

A third data bus 224 coupled between the SIM software 224 and the mass storage software 213 acts as a bridge between the two applications or blocks and may enable the host device to access SIM data of the NAND Flash memory through the high speed second bus 218. Therefore, the slow ISO protocol first bus 216 may be bypassed. The user may then experience a faster response in accessing SIM data.

The third bus 224 may be a link between the two software applications that may be embedded in the combo-SIM card. Accordingly, there may be several different approaches as to how to access the SIM data stored in the NAND Flash memory. During initialization, and/or any activation and/or deactivation it may be preferred to process a command for access to the security related SIM data stored in the NAND Flash memory through the ISO bus being the first bus 216. Alternatively, all ISO commands may be processed through the second bus 218 and the third bus 224.

A situation may call for a portion of a command being related to security and therefore it may be preferred process that portion of the command through the first bus 216 which is the ISO bus. On the other hand, a command may request directory and elementary fields of the SIM card which may not necessarily contain security elements. Accordingly, another alternative embodiment is that part of an ISO command may be processed through the second bus 218 and the third bus 224.

In general, the two hardware interfaces, the first bus 216 and the second bus 218 may be used in parallel or serially, It is understood that command and security requirement situations may be different for different use cases. It is further understood that a bus or buses through which the data may be stored in memory of the SIM card may be accessed in many different manners and combinations thereof.

An ISO command that seeks to retrieve data or access the NAND Flash memory may be sent to the mass storage software 213 of the microprocessor chip 202 through the second bus from the host device interface 212. When sent through the second bus, the ISO command may encapsulated in the data portion of the protocol used prior to sending the command to the mass storage block. Encapsulation of the ISO command to be received by the mass storage software may include a header identifying that the data or access sought is directed to the SIM memory. The mass storage block may issue commands to the SIM software across the third data bus. Accordingly, the mass storage software may provide an intelligent gateway to support macro commands across the third data bus between the mass storage software and the SIM software. Macro commands may offer encapsulation as well as de-encapsulation services. For example, an ISO messages embedded in a DATA messages coming from the second bus from the host device interface 212 may be de-encapsulated using a macro command before being sent via the third bus 224 with addition of a routing header. When the ISO command returns, it may then be encapsulated in a similar way using a macro. The SIM software may then direct the access to the SIM data through the third data bus. The SIM data may then be transferred via the third bus 224 and the second bus 218 to the host device interface. The mass storage software may further enable instructions to facilitate security for SIM data accessed by third bus 224 and the second bus 218.

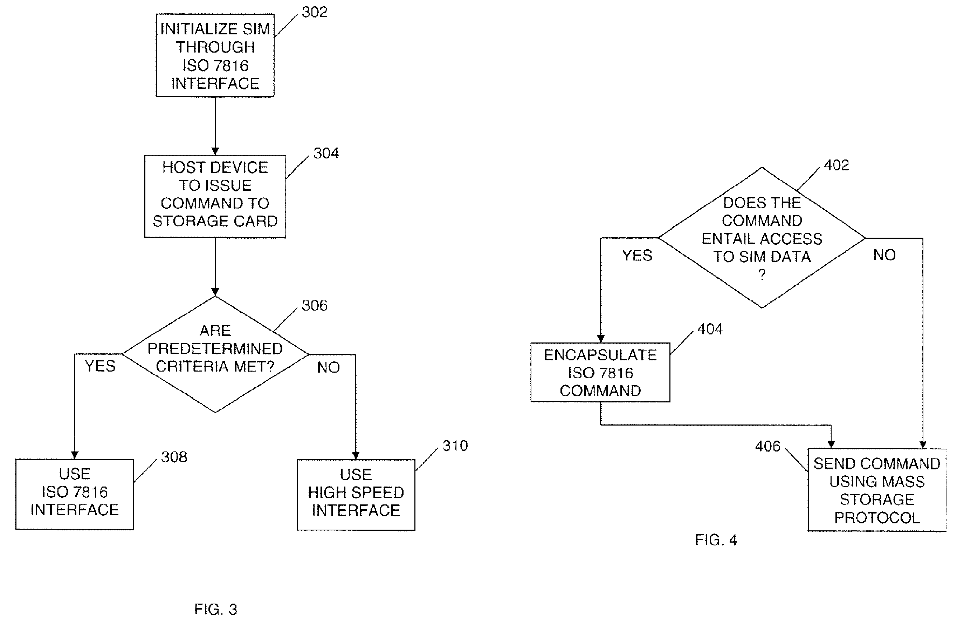

FIGS. 3-6 are flow charts illustrating embodiments of the methods as described herein, FIG. 3 is a flow chart showing the initialization process that the described combo-SIM card may follow, As mentioned above, an initialization command 302 from the host device interface may send an ISO command 304 through the first bus to the SIM software or may send a command to the mass storage software through the second bus. The command may be generated by an accessing module and delivered by a command module (see 116 and 118 of FIG. 1). The host device may determine if predetermined criteria are met 306 to direct the command either through the first bus or the second bus. The predetermined criteria may include a determination of whether the SIM data access command is encapsulated. If the command is a security command, the command may preferably be an ISO command and the data may be retrieved through the first bus 308. If the command is for access other than to security data, then the command may be sent through the second bus to the mass storage software and then SIM data may be retrieved from the NAND Flash memory through the third and second bus 310.

FIG. 4 is a flow chart of an encapsulation process. In the event that the accessing and command module intend to deliver a command to the mass storage software to access the NAND Flash memory for SIM data 402, an encapsulating module (see 120 of FIG. 1) may encapsulate the command to access SIM data prior to sending the command to the mass storage software 404 via the second bus 406. The host device interface may include a receiver module (see 122 of FIG. 1) for receiving SIM data transferred across the third bus and the second bus.

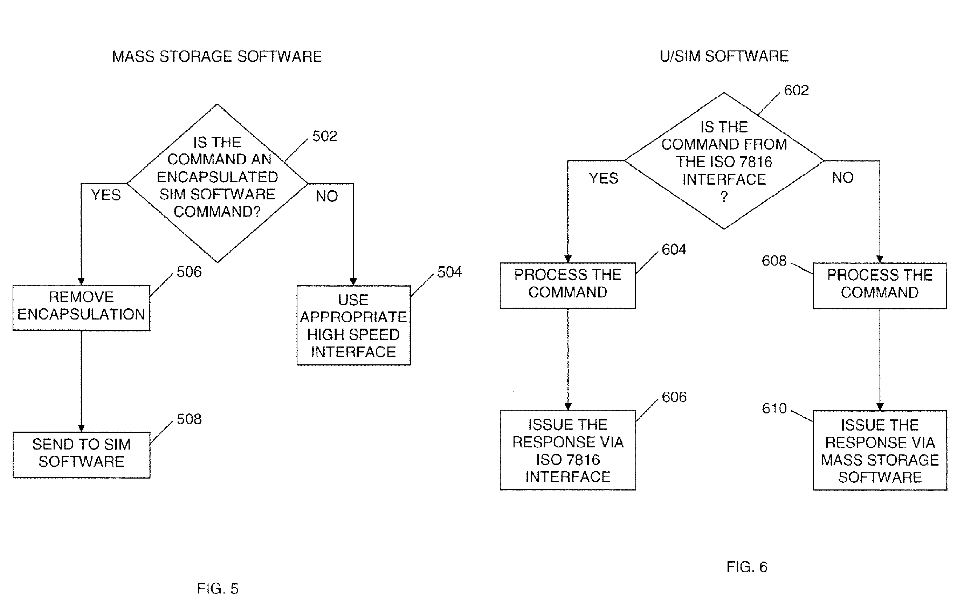

FIG. 5 is a flow chart of mass storage software determining whether the command is encapsulated for accessing the SIM data. The mass storage software application may receive a command and determine whether it is an encapsulated SIM software command 502. If the command is not an encapsulated SIM software command, the mass storage software may access the RAM and deliver the RAM data via the appropriate high speed interface, such being the second bus 504, If on the other hand, the command is an encapsulated SIM software command, the mass storage software will remove the encapsulation 506 and deliver the command to the SIM software 508.

FIG. 6 is a flow chart of the SIM software accessing the SIM data via the third bus or accessing RAM data. The SIM software may determine whether the command came from the first bus or third bus 602. If the command was delivered via the first bus then the SIM software may process the command 604 and issue a response via the ISO interface or first bus 606. If the command was delivered via the third bus then the SIM software may process the command 608 and issue a response via the mass storage software 610, that is, via the third bus and the second bus. The host device interface may include a response module (see 124 of FIG. 1) for receiving a response from the SIM software over the third and second bus.

By linking the mass storage software and SIM software or blocks so that the SIM data transfer may benefit from the speed of the high speed bus, the user may benefit by both receiving sensitive data via the ISO interface when appropriate and by receiving data that is not sensitive but stored in the SIM data memory via a high speed connection when appropriate. Accordingly, the host device may re-allocate to other purposes RAM that might be otherwise used to cache the SIM data,

This disclosure is intended to explain how to fashion and use various embodiments in accordance with the technology rather than to limit the true, intended, and fair scope and spirit thereof. The foregoing description is not intended to be exhaustive or to be limited to the precise forms disclosed. Modifications or variations are possible in light of the above teachings. The embodiment(s) was chosen and described to provide the best illustration of the principle of the described technology and its practical application, and to enable one of ordinary skill in the art to utilize the technology in various embodiments and with various modifications as are suited to the particular use contemplated. All such modifications and variations are within the scope of the invention as determined by the appended claims, as may be amended during the pendency of this application for patent, and all equivalents thereof, when interpreted in accordance with the breadth to which they are fairly, legally and equitable entitled.

## Claims

1. A memory card for an electronic device comprising:
an external interface;
first and second data buses operatively coupled to the external interface, the second data bus having faster data transfer capability than the first data bus;
a subscriber identity block coupled to the external interface via the first data bus, the subscriber identity block being effective to store subscriber identity information;
a mass storage block coupled to the external interface via the second data bus, the mass storage block being effective to store non-subscriber identity information; and
a third data bus coupled between the subscriber identity block and the mass storage block, the third data bus having faster data transfer capability than the first data bus.

2. The memory card of Claim 1, the mass storage block further being effective to provide an intelligent gateway to support macro commands across the third data bus.

3. The memory card of Claim 1, the mass storage block further being effective to issue commands to the subscriber identity block across the third data bus.

4. The memory card of Claim 1, wherein the mass storage block comprises instructions to facilitate increased security for data stored in the subscriber identity block and accessed across the third data bus.

5. A mobile communication device incorporating the memory card of Claim 1.

6. A method in an electronic device incorporating a memory card having a subscriber identity block and a mass storage block coupled to an interface, the method comprising:
accessing by the interface data associated with the subscriber identity block using a data bus between the mass storage block and the subscriber identity block.

7. The method of Claim 6, further comprising:
transferring the subscriber identity block data across a data bus coupling the mass storage block to the interface.

8. The method of Claim 6, wherein accessing by the interface subscriber identity block data comprises:
sending a command to the mass storage block to access subscriber identity block data using the data bus between the mass storage block and the subscriber identity block.

9. The method of Claim 6, further comprising:
encapsulating the command to access subscriber identity block data prior to sending the command to the mass storage block.

10. The method of Claim 6, further comprising:
sending a response from the subscriber identity block over the data bus between the mass storage block and the subscriber identity block if the command came over the data bus between the mass storage block and the subscriber identity block.

11. A method in a memory card including a subscriber identity block with an associated first data bus, a mass storage block with an associated second data bus, and a third data bus therebetween, the method for accessing subscriber identity data through the mass storage block, the method comprising;
receiving a request for initialization data through the first data bus;
receiving a request for data in the subscriber identity block through the second data bus and the third data bus; and
transmitting the additional data in the subscriber identity block through the third data bus and the second data bus.

12. The method of Claim 11, wherein receiving a request for additional data in the mass storage block comprises:
receiving through the second data bus an encapsulated command to access subscriber identity block data;
processing the encapsulated command to produce an unencapsulated command; and
sending through the third data bus the unencapsulated command to the subscriber identity block.

13. The method of Claim 11, wherein the second and third data buses transfer data at a faster rate than the first data bus.

14. An electronic device comprising a memory card having a subscriber identity block and a mass storage block operatively coupled to an interface, the method comprising:
an accessing module for accessing by the interface data associated with the subscriber identity block using a data bus between the mass storage block and the subscriber identity block.

15. The device of Claim 14, further comprising:
a command module for sending a command to the mass storage block to access subscriber identity block data using the data bus between the mass storage block and the subscriber identity block.

16. The device of Claim 15, further comprising:
an encapsulating module for encapsulating the command to access subscriber identity block data prior to sending the command to the mass storage block.

17. The device of Claim 14, further comprising:
a receiver module for receiving subscriber identity block data transferred across a data bus operatively coupling the mass storage block to the interface.

18. The device of Claim 14, further comprising:
a response module for receiving a response from the subscriber identity block over the data bus between the mass storage block and the subscriber identity block if the command was sent over the data bus between the mass storage block and the subscriber identity block.
